# EUROPÄISCHE PATENTSCHRIFT

(11) **EP 1 915 787 B1**
(45) Veröffentlichungstag und Bekanntmachung des Hinweises auf die Patenterteilung: **28.03.2012**
(21) Anmeldenummer: 06764276.9
(22) Anmeldetag: 31.07.2006
(51) Int. Cl.: H01L 41/09, H01L 41/04, H01L 41/083, H02N 2/00

(54) **PIEZOELEKTRISCHER AKTOR FÜR EINEN ULTRASCHALLMOTOR**
PIEZOELECTRIC ACTUATOR FOR AN ULTRASONIC MOTOR
ACTIONNEUR PIEZOELECTRIQUE POUR MOTEUR A ULTRASONS

(30) Priorität: 19.08.2005 DE 102005039358
(43) Veröffentlichungstag der Anmeldung: 30.04.2008
(73) Patentinhaber: Physik Instrumente (PI) GmbH & Co. KG, 76228 Karlsruhe (DE)
(72) Erfinder: WISCHNEWSKIJ, Wladimir, 76337 Waldbronn (DE); WISCHNEWSKIJ, Alexej, 76744 Wörth (DE)
(74) Vertreter: Meissner, Bolte & Partner
(86) Internationale Anmeldenummer: PCT/EP2006/064832
(87) Internationale Veröffentlichungsnummer: WO 2007/020177

(56) Entgegenhaltungen:
- EP-A2- 1 267 425
- WO-A-00/74153
- WO-A-2006/099924
- US-A1- 2005 052 095

## Beschreibung

Die Erfindung betrifft piezoelektrische Aktoren für rotatorische Ultraschall-und Linearmotoren. Diese können zum Antrieb von Motoren für Linear- und Drehbewegungen eingesetzt werden. Sie können außerdem zum Antrieb von Geräteträgern, optischen Linsen, optischen Schreib- und Leseköpfen und für weitere ähnliche Vorrichtungen eingesetzt werden, bei denen eine hohe Positioniergenauigkeit, kleine Abmessungen des Antriebsystems und niedrige Versorgungsspannungen gefordert werden.

Bekannt sind piezoelektrische Aktoren für Ultraschallmotoren, die aus einem Metallresonator für akustische Wellen, mit aufgeklebten lamellenartigen Piezoelementen, die im Resonator akustische Wellen erregen, bestehen (siehe u.a. US 5,665,918; US 5,672,930).

Der Nachteil dieser Aktoren besteht in ihren großen Abmessungen, die durch die Abmessungen des metallischen Resonators bestimmt werden. Außerdem besitzen diese Aktoren ein kleines Volumen des piezoelektrisch aktiven Teils und eine große Dicke des Piezoelementes. Dies verringert wesentlich den elektromechanischen Kopplungskoeffizienten, wodurch die Anregungsspannung bedeutend höher ist. Solche Aktoren sind zudem kompliziert im Aufbau, was eine Handmontage erfordert und die Herstellungskosten erhöht.

Bekannt sind auch piezoelektrische Aktoren für Ultraschallmotoren (siehe u.a. US 5,134,334; US 5,416,375), bei denen die Piezoelemente als dünne Lamellenpakete mit dem metallischen Resonator verbunden sind. Die Nachteile dieser Aktoren sind ihre großen Abmessungen, der komplizierte Aufbau und die hohen Herstellungskosten.

Gemäß der Lehre nach EP 1 267 425 A2 ist ein Ultraschallmotor bekannt, in dessen Aktor gleichzeitig zwei stehende Longitudinalwellen angeregt werden. Eine Welle breitet sich längs zur Aktorlänge aus. Die zweite Welle breitet sich hingegen entlang der Aktorhöhe aus. Eine gleichzeitige Anregung von zwei Longitudinalwellen führt zu einer elliptischen Bewegung des Friktionselements. Der in EP 1 267 425 A2 offenbarte Resonator besteht aus mehreren verklebten Einzelresonatoren.

Beim in der WO 00/74153 A1 beschriebenen Aktor werden entlang der Oszillatorlänge gleichzeitig eine Biege- und Longitudinalwelle anregt. Die geometrischen Abmessung des Aktors sind dabei derart gewählt, dass die Resonanzfrequenzen dieser Wellen nahe beieinander liegen, wobei die Elektrodenkonfiguration sowie ihre Beschaltung derart ausgeführt sind, dass die Anregung dieser Wellen gleichzeitig erfolgt. Als Resultat bewegen sich die mittleren Bereiche der Stirnflächen des Aktors entlang elliptischer Bahnen. Daher sind die Friktionselemente an den Stirnseiten des Aktors angeordnet.

Bekannt sind weiterhin piezoelektrische Aktoren für Ultraschallmotoren, die als piezoelektrische Platten aufgebaut sind, bei denen auf ihren zwei Hauptflächen Elektroden aufgebracht sind (siehe u.a. US 6.384.514; US 7.714. 833).

Der Nachteil ist, das diese Aktoren eine hohe Anregungsspannung benötigen. Das ist dadurch erklärbar, dass eine Biegeresonanz mit einem niedrigen elektromechanischen Kopplungskoeffizienten verwendet wird. Die maximale Anregungsspannung solcher Aktoren erreicht Werte von 300 V_{eff}. Ein weiterer wesentlicher Nachteil ist das Vorhandensein einer zweiten, im Bereich der Biegeresonanz liegenden Longitudinalresonanz. Dies erschwert die Steuerung dieser Aktoren, was zur Folge hat, dass es unmöglich ist, einfache nach dem Prinzip der Eigenerregung arbeitende Anregungsschaltungen zu bauen, bei denen die Erregerfrequenz durch den Aktor selbst vorgegeben wird. Dies führt zu einer wesentlichen Verringerung der Temperaturstabilität des Antriebs, senkt die Betriebssicherheit der Aktoren und verteuert die Herstellung.

Bekannt sind zudem miniaturisierte piezoelektrische Aktoren für Ultraschallmotoren, in denen das Multilayerpiezoelement in den Körper des Metallresonators eingepresst ist (siehe u.a. US 2004/0256954 A1). Diese Aktoren haben kleine Abmessungen und niedrige Anregungsspannungen.

Das Funktionsprinzip dieser Aktoren beruht auf der Erregung von zwei Typen von Stehwellen im Resonanzkörper auf nah beieinander liegenden Resonanzfrequenzen. Deshalb muss zur Richtungsumkehr des beweglichen Elementes die Frequenz der Anregungsschaltung von der einen auf die andere Resonanzfrequenz abgestimmt werden. Dadurch ist es nicht möglich, eine Anregungsschaltung aufzubauen, die auf dem Prinzip der Eigenerregung basiert, deren Frequenz durch die mechanischen Parameter des Aktors vorgegeben wird. Dadurch wird die Betriebstabilität des Aktors verringert, der Aufbau der Anregungsschaltung erschwert und das Antriebssystem insgesamt verteuert. Aufgabe der Erfindung ist es, einen verbesserten piezoelektrischen Aktor der gattungsgemäßen Art bereitzustellen, der sich durch kleinere Abmessungen, niedrigere Erregerspannungen, größere Betriebsstabilität und -sicherheit sowie eine vereinfachte Ansteuerung und geringere Herstellungskosten auszeichnet.

Diese Aufgabe wird durch eine Vorrichtung mit den Merkmalen des Anspruchs 1 gelöst. Zweckmäßige Fortbildungen des Erfindungsgedankens sind Gegenstand der abhängigen Ansprüche.

Die Erfindung schließt den Gedanken des Aufbaus eines piezoelektrischen Aktors für Ultraschallmotoren mit einer Steuereinheit für diesen Aktor in einer konstruktiven Ausführung ein, die eine einfach aufgebaute Erregervorrichtung in der Steuereinheit ermöglicht, die nach dem Prinzip der Eigenerregung arbeitet, wobei deren Erregerfrequenz durch die mechanischen Parameter des Aktors vorgegeben wird.

Es ist vorgesehen, dass in dem piezoelektrischen Aktor für den Ultraschallmotor, der aus einem akustischen Schwingungsresonator mit einem Multilayergenerator für eine akustische Stehwelle besteht, der akustische Schwingungsresonator als rechteckige piezoelektrische Platte mit jeweils zwei Haupt, zwei Seiten- und zwei Stirnflächen ausgeführt ist, wobei mindestens auf einer der Seitenflächen ein Friktionselement oder eine Friktionsschicht angeordnet ist und der Schwingungsresonator im Inneren eine Multilayerstruktur hat. Diese stellt Schichten von Anregungselektroden dar, die sich mit den Schichten der gemeinsamen Elektroden und den zwischen ihnen sich befindenden Schichten polarisierter Keramik abwechseln, wobei der Polarisationsvektor senkrecht zur Fläche der Elektroden verläuft. Alle Anregungselektroden sind in zwei miteinander nicht verbundene Gruppen geteilt, die symmetrisch zur Symmetriefläche der erwähnten Platte angeordnet sind. Dabei verläuft diese Symmetriefläche senkrecht zu den Haupt- und Seitenflächen der Platte, und zwar durch ihre Mitte, wobei jede Gruppe der Anregungselektroden zusammen mit den gemeinsamen Elektroden und der Piezokeramik zwischen ihnen einen, auf die Symmetriefläche der piezoelektrischen Platte bezogen, asymmetrisch angeordneten Multilayergenerator für eine akustische Welle bildet.

Das Auftreten der Resonanz und die Resonanzfrequenz der asymmetrischen Stehwelle selbst wird durch das gewählte Verhältnis der Länge zur Höhe und die konstruktive Ausführung der Generatoren für akustische Schwingungen bestimmt, wobei diese Generatoren asymmetrisch zur Symmetriefläche der Platte angeordnet sind. Das Verhältnis der Länge zur Höhe beträgt im Wesentlichen 2,25. Die Resonanzfrequenz bzw. Erregerfrequenz der piezokeramischen Platte entspricht dem Verhältnis Länger der piezokeramischen Platter zur Frequenzkonstate der piezokeramischen Platte.

In einer bevorzugten Ausführung des piezoelektrischen Aktors können die gemeinsamen Elektroden aus zwei Teilen bestehen, deren Konfiguration die Konfiguration der Anregungselektroden wiederholt. Das erweitert die Einsatzmöglichkeiten des vorgeschlagenen Aktors.

In den unterschiedlichen Ausführungsvarianten des Aktors können die Anregungselektroden und die gemeinsamen Elektroden parallel zu den Stirnflächen der piezoelektrischen Platte angeordnet sein. Dadurch erhöht sich die Längskomponente der Deformation des Aktors.

In anderen Varianten des piezoelektrischen Aktors für den Ultraschallmotor können die Anregungselektroden und die gemeinsamen Elektroden parallel zu den Seitenkanten der piezoelektrischen Platte angeordnet sein. Dadurch erhöht sich die Vertikalkomponente der Deformation des Aktors.

In den folgenden zweckmäßigen Ausführungen des Aktors können die Anregungselektroden und die gemeinsamen Elektroden parallel zu den Hauptflächen der piezoelektrischen Platte angeordnet sein. Das gleicht unterschiedliche Erregerintensität zwischen Längs- und Vertikaldeformationskomponenten des Aktors aus.

In dem vorgeschlagenen Aktor können auf mindestens einer Seitenfläche der piezoelektrischen Platte des Ultraschallmotors stromleitende Elektroden aufgebracht sein, die Anregungs- und gemeinsame Elektroden untereinander verbinden.

Die stromleitenden Elektroden, die Anregungselektroden und gemeinsame Elektroden miteinander verbinden, können auch auf mindestens einer der Hauptflächen der piezoelektrischen Platte aufgetragen sein.

Die stromleitenden Elektroden, die Anregungselektroden und gemeinsame Elektroden miteinander verbinden, können auch auf den Stirnflächen der piezoelektrischen Platte aufgebracht sein.

Das alles erweitert die konstruktiven Möglichkeiten des erfindungsgemäßen Aktors.

In einigen Varianten des vorgeschlagenen piezoelektrischen Aktors ist auf mindestens einer der Seitenflächen der piezoelektrischen Platte des Aktors ein Friktionselement vorgesehen. Das ermöglicht es, den vorgeschlagenen Aktor in Motoren mit beweglicher Friktionsschiene einzusetzen.

In anderen Varianten des erfindungsgemäßen piezoelektrischen Aktors ist auf mindestens einer der Seitenflächen der piezoelektrischen Platte des Aktors eine Friktionsschicht vorgesehen. Dies ermöglicht es, den vorgeschlagenen Aktor in Motoren mit Gleitstücken einzusetzen.

Im Rahmen der Erfindung kann die Steuereinheit des Aktors aus einem Einkanalautogenerator mit einem Leistungsverstärker und einem Rückkopplungszweig bestehen, mit einem Rückkopplungselement und einem Richtungsumschalter, der abwechselnd den Leistungsverstärker mit dem entsprechenden Generator der akustischen Welle verbindet. Dies ermöglicht es, die Steuereinheit zu vereinfachen.

Die Steuereinheit für den Aktor kann auch aus einem Zweikanalautogenerator mit zwei Leistungsverstärkern und einem Rückkopplungszweig bestehen, mit einem Rückkopplungselement und einem Richtungsumschalter, der abwechselnd den Rückkopplungszweig mit dem entsprechenden Kanal des Autogenerators verbindet. Dies erhöht den Wirkungsgrad des Aktors.

In der Steuereinheit für den Aktor kann das Rückkopplungselement aus einem Widerstand, einem Kondensator oder aus beiden Bauteilen bestehen, die parallel geschaltet und mit der Gruppe der gemeinsamen Elektroden des piezoelektrischen Aktors verbunden sind. Dies vereinfacht das Rückkopplungselement.

In jeder beliebigen Variante der Steuereinheit des Aktors kann das Rückkopplungselement einen Kondensator eines durchstimmbaren Filters in Form eines Serien-LC-Kreises aufweisen, der mit der Gruppe der gemeinsamen Elektroden des piezoelektrischen Aktors verbunden ist. Dies ermöglicht es, die Spannung im Rückkopplungszweig zu erhöhen.

In der Steuereinheit des vorgeschlagenen Aktors kann die Kapazität des Kondensators im Rückkopplungszweig des Serien-LC-Kreises mit durchstimmbaren Filter gleich der elektrischen Kapazität des Aktors zwischen einer der Gruppen der Anregungselektroden und einer Gruppe der gemeinsamen Elektroden sein. Das optimiert die Parameter des durchstimmbaren Filters.

Zusätzlich kann die Steuereinheit des erfindungsgemäßen Aktors einen Breitimpulsspannungsregler aufweisen, dessen Ausgang mit dem Eingang der Spannungsquelle des Einkanal- oder Zweikanalautogenerators verbunden ist, wobei sein Steuereingang den Analogeingang zur Steuerung des Anregungsniveaus des Aktors bildet. Dadurch ist eine Analogsteuerung des Aktors möglich.

Der Synchronisierungseingang des Breitimpulsspannungsreglers kann in der Steuereinheit des Aktors direkt oder über einen Frequenzvervielfacher mit dem Signalkreis des Einkanal- oder Zweikanalautogenerators verbunden sein. Dadurch ist es möglich, den Störschutz der Baugruppe und seine Arbeitsgeschwindigkeit zu erhöhen.

Vorteile und Zweckmäßigkeiten der Erfindungen werden deutlicher aus der nachfolgenden Beschreibung bevorzugter Ausführungsbeispiele anhand der Figuren. Von diesen zeigen:
- Fig. 1: Hauptvariante des vorgeschlagenen Aktors,
- Fig. 2: Elektrodenkonfiguration der Grundvariante des vorgeschlagenen Aktors,
- Fig. 3: Polarisationsrichtung der Piezokeramik des Aktors,
- Fig. 4: Ausführungsvariante des vorgeschlagenen Aktors,
- Fig. 5: Ausführungsvariante der Aktorelektroden nach Fig. 4,
- Fig. 6: erfindungsgemäße Ausführung des Aktors,
- Fig. 7: Elektrodenkonfiguration des Aktors nach Fig. 6,
- Fig. 8: Ausführungsvariante des vorgeschlagenen Aktors,
- Fig. 9: Variante der Elektrodenkonfiguration des Aktors nach Fig. 8,
- Fig. 10: Variante der Elektrodenkonfiguration des Aktors nach Fig. 8,
- Fig. 11: Ausführungsvariante des vorgeschlagenen Aktors,
- Fig. 12: Variante der Elektrodenkonfiguration des Aktors nach Fig. 11,
- Fig. 13: einen Aktor mit einem Friktionselement,
- Fig. 14: einen Aktor mit zwei Friktionselementen,
- Fig. 15: einen Aktor mit einer Friktionsschicht ,
- Fig. 16: einen Aktor mit zwei Friktionsschichten,
- Fig. 17: einen Aktor mit einer Steuereinheit,
- Fig. 18: Zeichnungen zur Erläuterung des Funktionsprinzips des vorgeschlagenen Aktors,
- Fig. 19, 20: Ausführungsvarianten von Ultraschallmotoren mit dem vorgeschlagenen Aktor,
- Fig. 21: Frequenzkennlinien des vorgeschlagenen Aktors,
- Fig. 22: elektrische Schaltung der Steuereinheit des Aktors mit einem Einkanalautogenerator,
- Fig. 23: elektrische Schaltung der Steuereinheit des Aktors mit einem Zweikanalautogenerator,
- Fig. 24: elektrische Schaltung der Steuereinheit des Aktors mit Breitimpulsspannungsregler,
- Fig. 25: Anwendungsbeispiel des vorgeschlagenen Aktors.

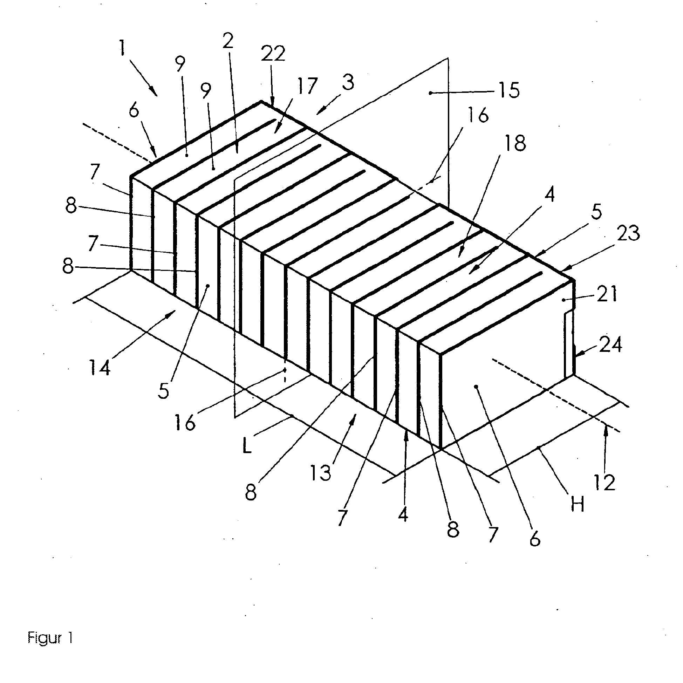

Fig. 1 zeigt einen piezoelektrischen Aktor 1 für Ultraschallmotoren. Er besteht aus einem akustischen Schwingungsresonator 2. Der Resonator 2 ist als rechtwinklige piezoelektrische Platte 3 mit zwei Hauptflächen 4, zwei Seitenflächen 5 und zwei Stirnflächen 6 ausgeführt. Dabei ist L die Plattenlänge 3 längs der Seitenfläche 5 und H die Höhe längs der Stirnfläche 6. Für den vorgeschlagenen Aktor 1 liegt das Verhältnis von L/H bei ca. 2,25.

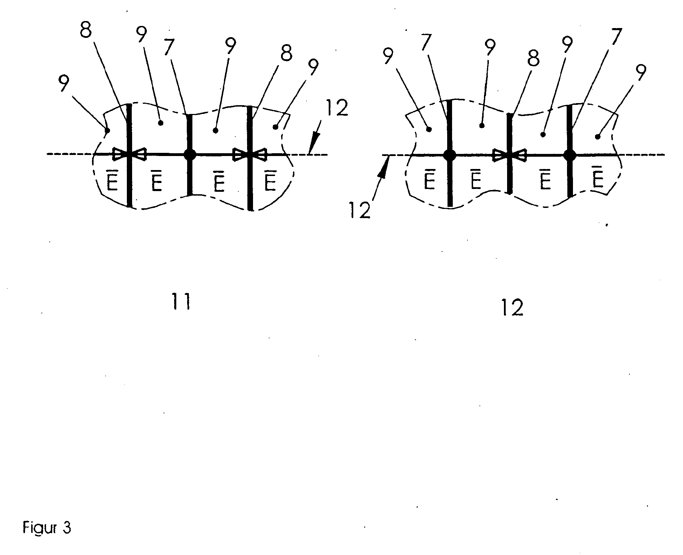

Die piezoelektrische Platte 3 hat im Inneren eine Multilayerstruktur, die gebildet ist aus parallelen Schichten von Anregungselektroden 7, die sich mit parallelen Schichten von gemeinsamen Elektroden 8 (siehe Fig. 3) und zwischen ihnen angeordneten Schichten polarisierter Piezokeramik 9 abwechseln, wobei der Polarisationsvektor senkrecht zu den Elektrodenflächen 7 und 8 verläuft, siehe Pfeile in Fig. 3, Position 10 und 11. Die Richtung des Polarisationsvektors fällt mit der der Polarisationsachse der piezoelektrischen Platte 3 zusammen, siehe punktierte Linie 12, dargestellt in Fig.3 sowie in anderen Figuren.

Alle Anregungselektroden 7 sind in zwei miteinander nicht verbundene Gruppen von Elektroden 13 und 14 aufgeteilt, die zueinander symmetrisch zu einer Symmetriefläche 15, die senkrecht zu den Hauptflächen 4 und den Seitenflächen 5 der Platte 3 und zwar durch die Mitte dieser Kanten verläuft, angeordnet sind. Die gestrichelte Linie 16 in Fig. 1 sowie in allen anderen Fig. zeigt die Schnittlinie der Fläche 15 mit den Flächen 4 und 5. Jede der Linien bildet die Mittelinie der entsprechenden Fläche.

Die Anregungselektrodengruppen 13 und 14 bilden zusammen mit Teilen der gemeinsamen Elektroden 7 und den zwischen ihnen angeordneten Piezokeramikschichten 9 Multilayergeneratoren 17 und 18 für die akustische Stehwelle. Jeder Generator 17 oder 18 ist asymmetrisch zur Symmetriefläche 15 angeordnet.

Die piezokeramische Multilayerplatte 3 wird entsprechend der Multilayertechnologie hergestellt. Allgemein kann diese Technologie wie folgt beschrieben werden: Zuerst wird ein dünnes Band aus niedrigtemperierten piezoelektrischem Rohmaterial hergestellt, in dem die Teilchen untereinander mit einem organischen Binder gebunden sind. Danach werden aus dem Band Bögen ausgeschnitten. Jetzt werden die Elektroden aus Palladiumpaste aufgetragen. Anschließend werden die Bögen als kompakter Block zur Platte 3 zusammengepresst und im Ofen gebrannt. Beim Brennen verflüchtigt sich das organische Bindemittel aus der Piezokeramik, die Piezokeramik wird gesintert, und aus der Palladiumpaste bilden sich die Metallelektroden. Bei dieser Technologie beträgt die übliche Schichtdicke 30 bis 50 Mikrometer.

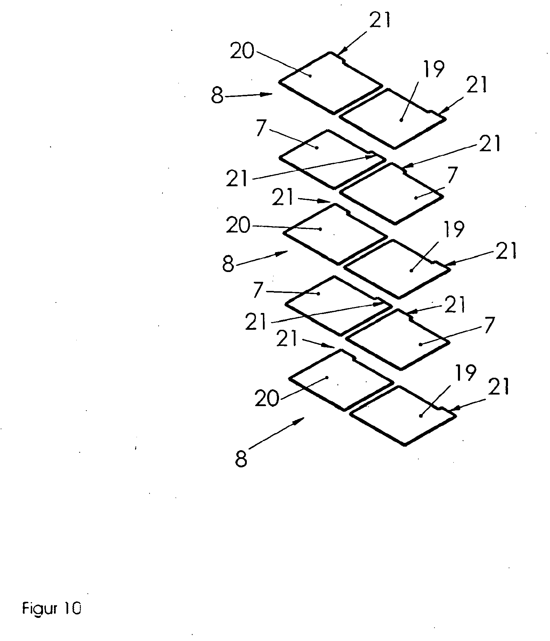

Die gemeinsamen Elektroden 8 können aus zwei gleichen Teilen 19 und 20 bestehen, die die in Fig. 10 dargestellte Konfiguration der Anregungselektroden 7 wiederholen.

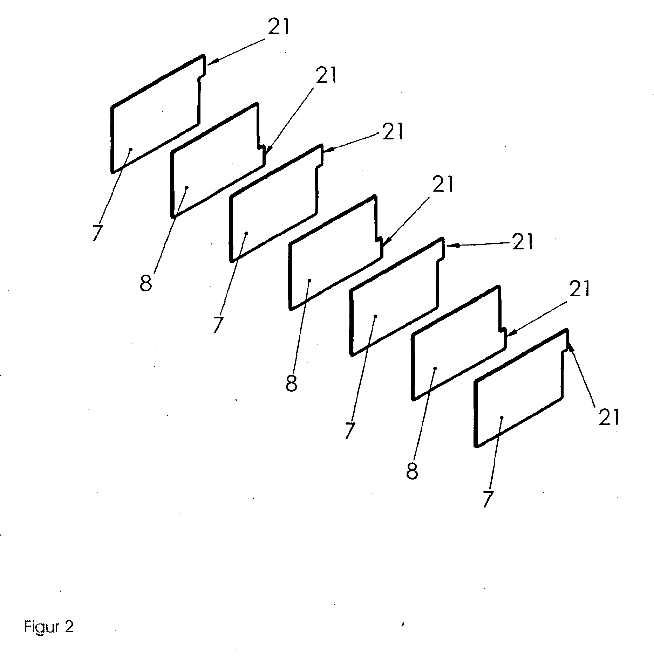

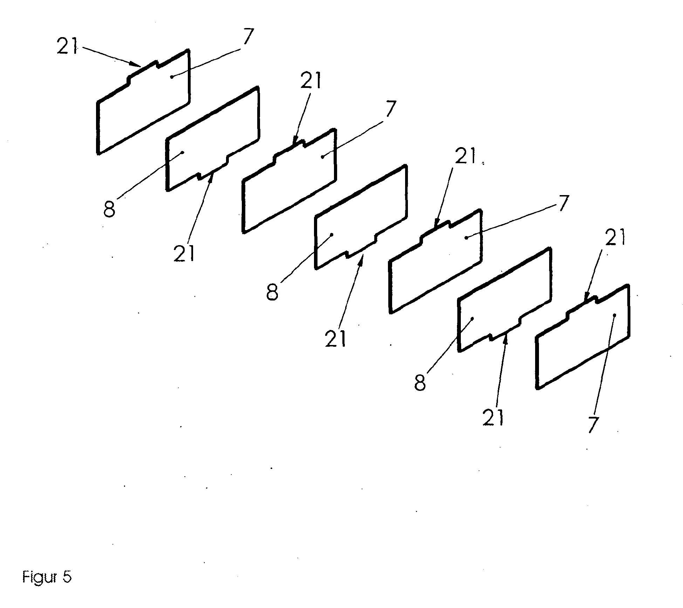

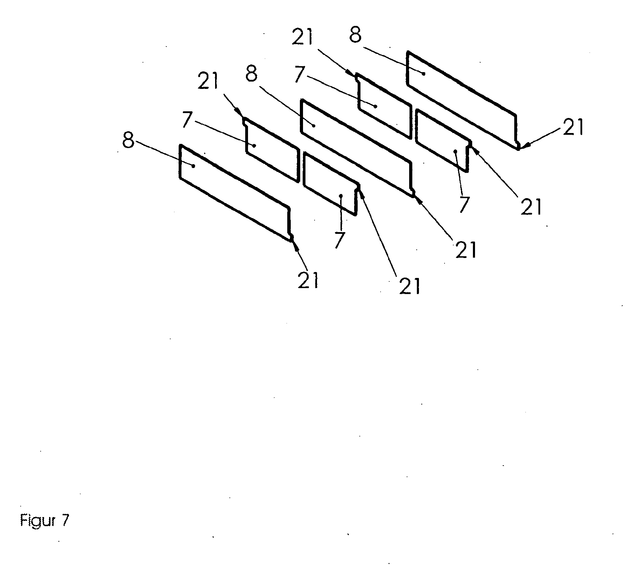

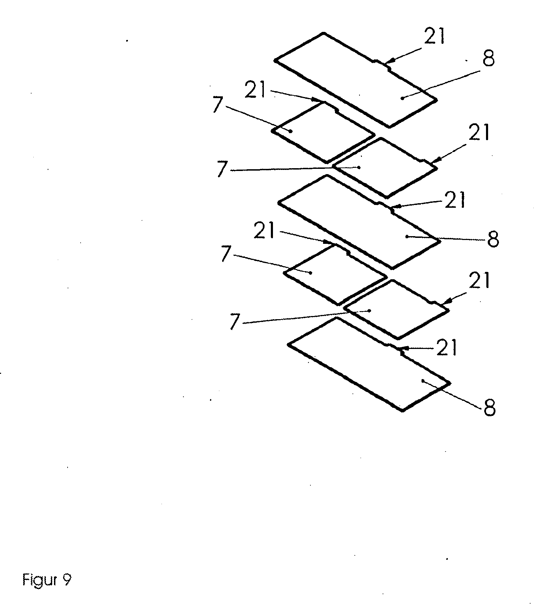

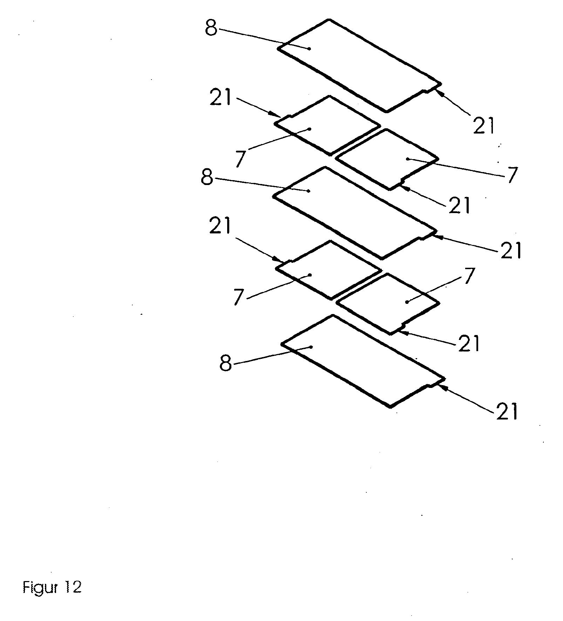

Jede der Elektroden 7, 8 oder jeder Teil 19, 20 der Elektroden weist einen stromleitenden Ansatz 21 auf (siehe Fig. 1, 2, 4, 5, 6, 7, 8, 9, 10, 11, 12), der elektrisch mit den stromleitenden Elektroden 22, 23 und 24 (siehe Fig. 1, 4, 6, 8, 11, 13, 14, 15, 16) verbunden ist.

Mittels Ionenzerstäubung von Chrom, Kupfer, Nickel, Silber und anschließendem Einbrennen können die stromleitenden Elektroden auf die Sinteroberfläche der Platte 3 aufgebracht werden.

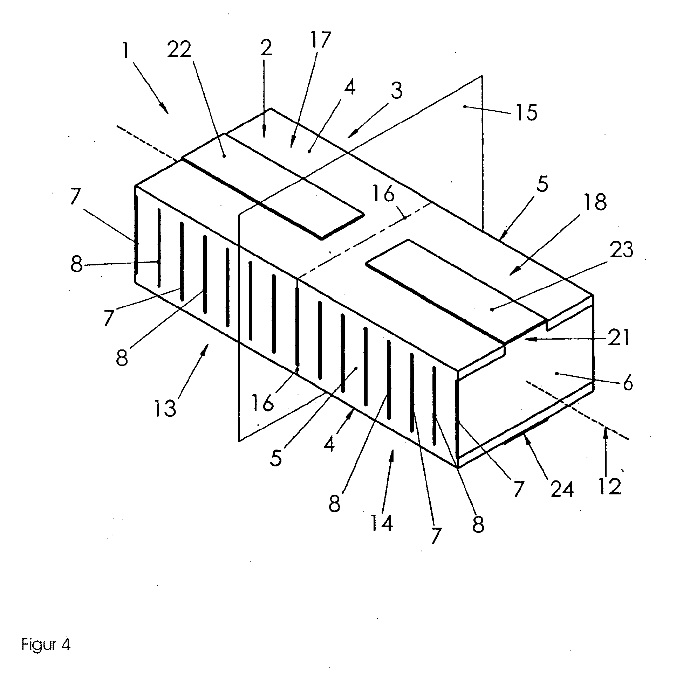

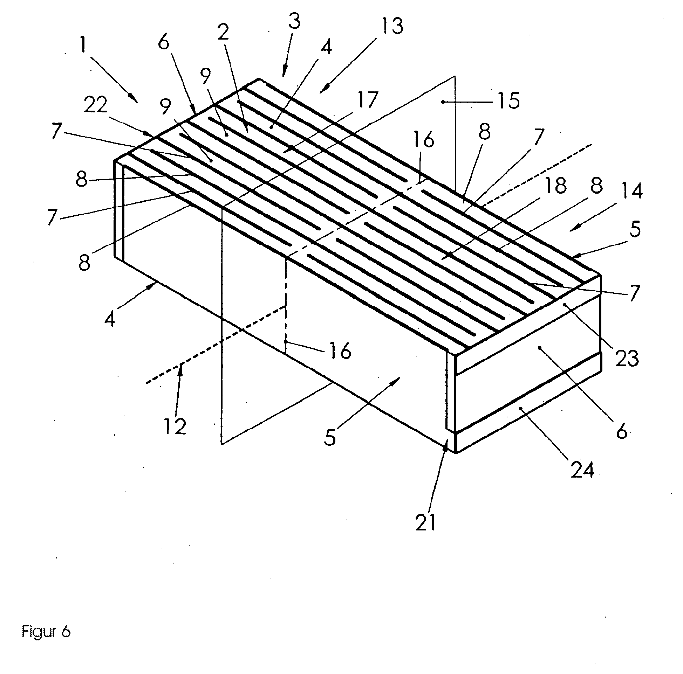

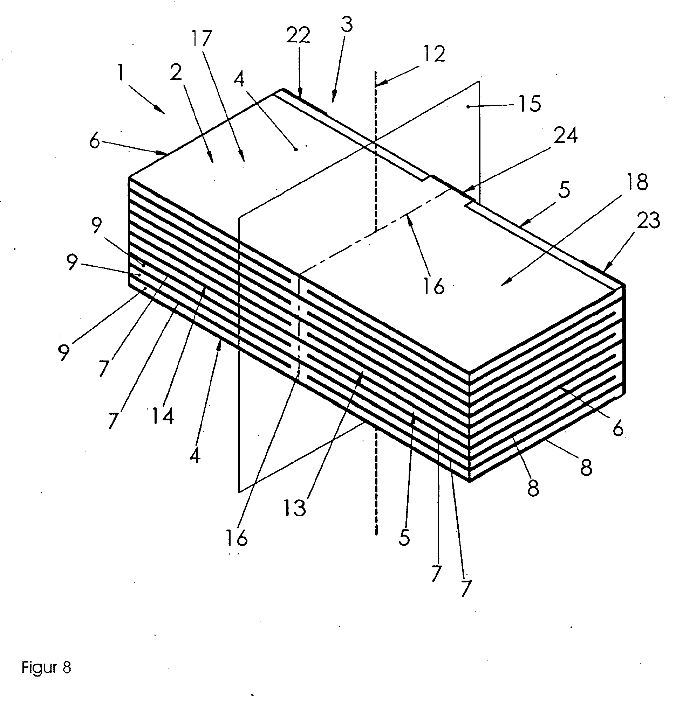

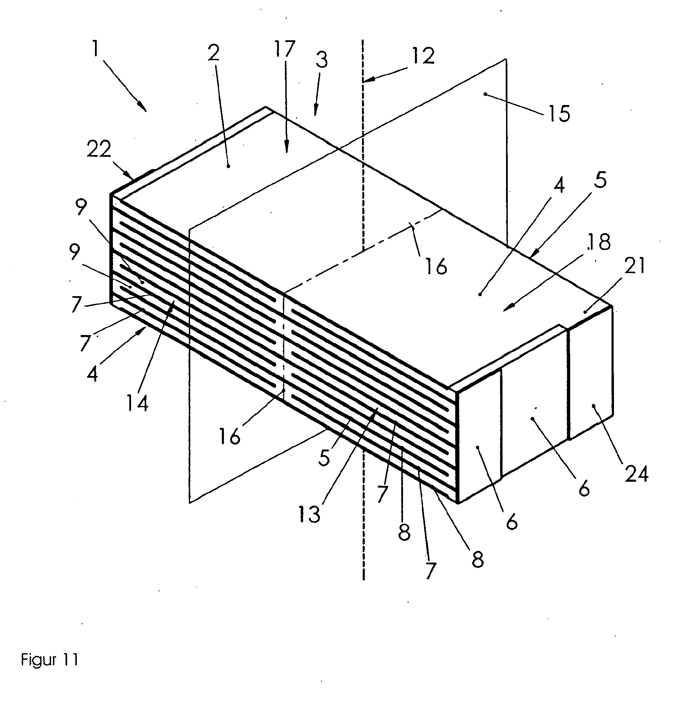

Im vorgeschlagenen Aktor können die Anregungselektroden 7 und die gemeinsamen Elektroden 8 parallel zu den Stirnflächen 6 der Platte (siehe Fig. 1, 4) angeordnet sein. Die Elektroden 7 und 8 können parallel zu den Seitenflächen 5 der Platte 3 angeordnet sein (siehe Fig. 6). Außerdem können die Elektroden 7 und 8 parallel zu den Hauptflächen 4 der Platte 3 angeordnet sein (siehe Fig. 8, 11).

Die stromleitenden Elektroden 22, 23, 24 können auf eine der Seitenflächen 5 der Platte 3 (siehe Fig. 1, 8, 13, 15) oder auf zwei dieser Flächen (in den Fig. nicht gezeigt) aufgetragen sein. Die stromleitenden Elektroden 22, 23, und 24 können auch auf einer (in den Fig. nicht dargestellt) oder zwei der Hauptflächen 4 der Platte 3 (siehe Fig. 4) aufgebracht sein. Die Elektroden 22, 23, 24 können auch auf die Stirnflächen 6 der Platte 3 (siehe Fig. 6, 11, 14, 16) aufgetragen sein.

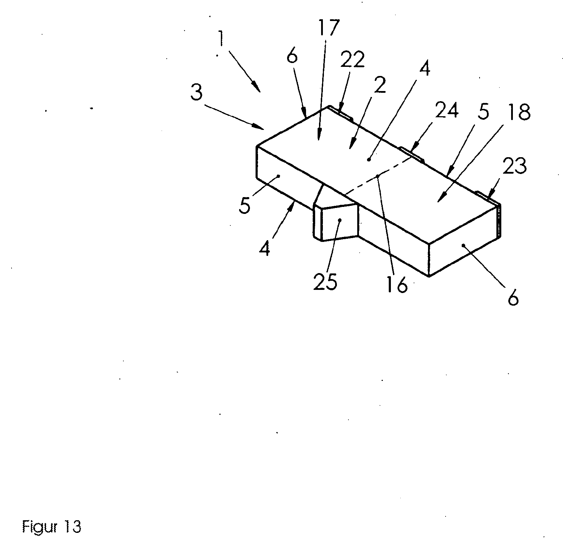

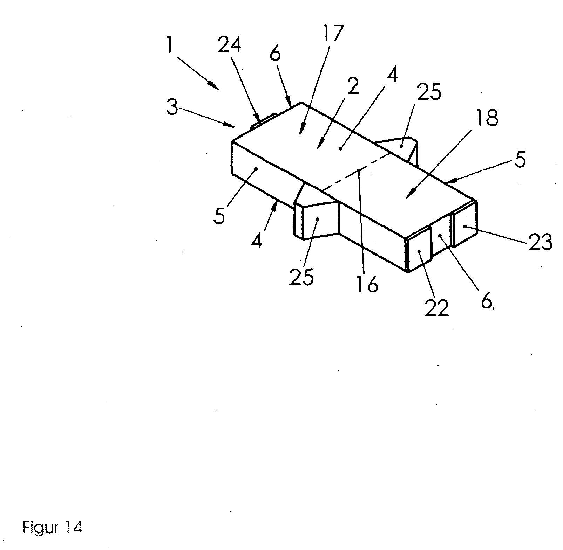

Wie in den in Fig. 13, 14 gezeigt, sind in den Ausführungsvarianten des vorgeschlagenen Oszillators auf einer oder zwei der Seitenflächen 5 der Platte 3 Friktionselemente 25 befestigt.

Die Friktionselemente werden aus einem harten, verschleißfesten Material, z.B. Aluminiumoxid Al₂O₃), Zirkonoxid ZrO₂, Siliziumnitrid Si₃N₄, Siliziumcarbid SiC, Bornitrid BN, Borcarbid B₄C, Wolframcarbid WC, Titancarbid TiC oder aus ähnlichem Material, hergestellt.

Diese verschleißfesten Elemente können durch Stoffe, die eine chemische Verbindung mit der piezoelektrischen Keramik der Platte 3 eingehen, auf der Platte 3 befestigt werden. Das kann durch bleihaltiges Glas oder ein ähnliches Material geschehen. Außerdem können die Elemente auch mit Epoxidharzkleber auf der Platte 3 aufgeklebt werden.

Die Friktionselemente können aus hartem verschleißfestem Kunststoff mit entsprechend beständigen Füllstoffen als Zusatz hergestellt werden. Zu diesen Füllstoffen gehört Material auf der Basis von Polyarylamid mit teilkristaliner Struktur und Glasfaser, Grafitfaser, Metallpulver, Oxidkeramikpulver oder anderes Material als Füllstoff, durch das der Kunststoff verfestigt und die Wärmeleitfähigkeit erhöht wird.

Mittels fest aushärtenden Epoxidharzklebern können diese Friktionselemente auf die Platte 3 aufgeklebt werden.

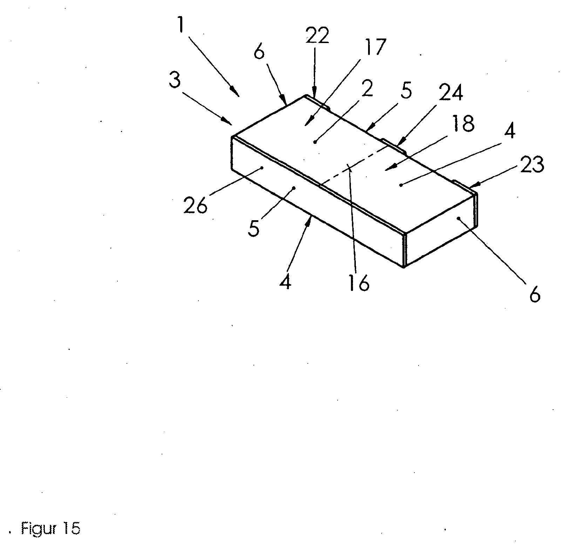

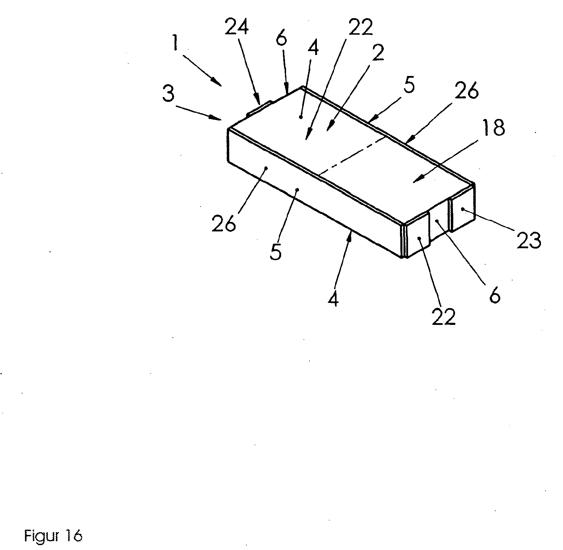

In weiteren Varianten des vorgeschlagenen Aktors sind, wie in Fig. 15, 16 gezeigt, Friktionsschichten 26 auf einer oder zwei der Seitenflächen 5 der Platte 3 angeordnet.

Die Friktionsschichten 26 können aus einer auf die Oberfläche der Platte 3 aufgeschmolzenen Schicht harten verschleißfesten Glases bestehen. In einem solchen Glas kann Aluminium-, Zirkoniumoxidpulver oder ein anderes verschleißfestes Material als Füllstoff eingesetzt werden. Die Schichten 26 können auch durch Aufdampfen einer dünnen Schicht aus Titan Ti, Chrom Cr, Titannitrid TiN, Titankarbid TiC, Titankarbidnitrid TiCN, Chromnitrid CrN, Titanaluminiumnitrid TiAIN, Zirkoniumnitrid ZrN, Titanzirkoniumnitrid TiZrN, Titanchromnitrid TiCrN oder anderen Material hergestellt werden.

Zum Schutz vor Feuchtigkeit kann die Oberfläche der Platte 4 des Aktors 1 mit einer dünnen Schicht aus organischem Lack, Glas, Keramik oder einem anderen elektrisch nichtleitenden Material (in den Fig. nicht dargestellt) überzogen werden.

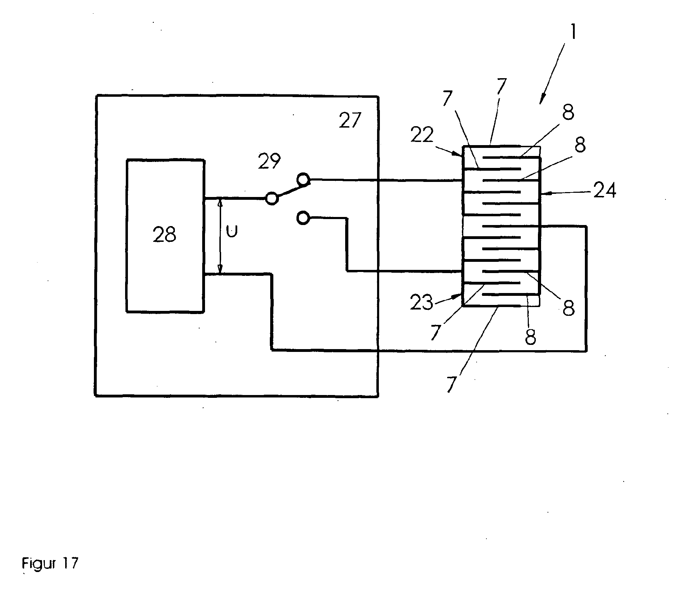

Eine zweckmäßige Ausführung sieht eine Steuerung 27 (siehe Fig. 17) vor, die aus einem Autogenerator 28 mit einem Richtungswahlschalter 29 besteht.

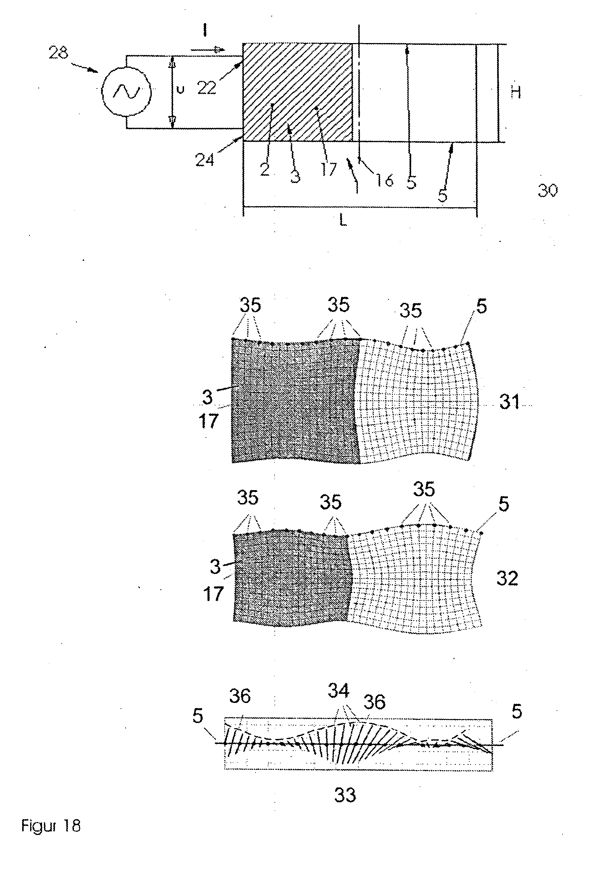

Fig. 18 zeigt eine Platte 30, den Generator für akustische Wellen 17, der mit dem Autogenerator 28 verbunden ist. An die Elektroden 7 und 8 wird eine elektrische Wechselspannung angelegt, wodurch der Strom i durch den Aktor fließt.
Fig. 18, Ziffern 31, 32 zeigen Verformungsbilder der Platte 3. Pos. 33 zeigt die Bewegungsbahn 34 der auf der Oberfläche der Seitenflächen 5 liegenden Punkte 35 und die Hüllkurve 36 der Bewegungsbahn 34.

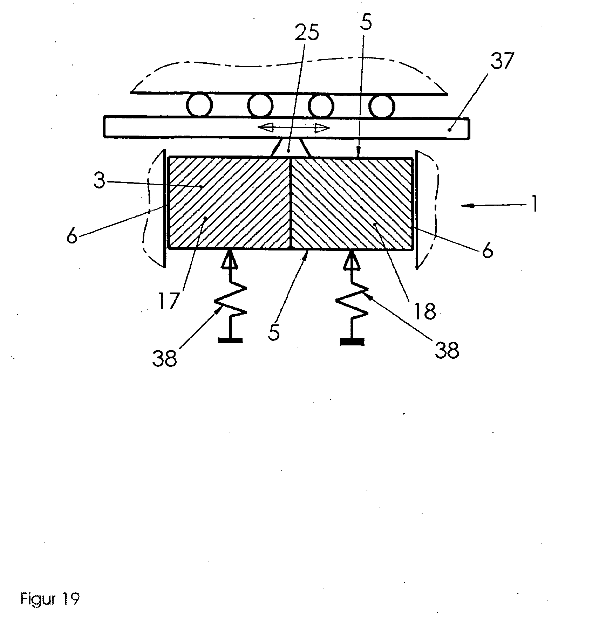

Fig. 19 zeigt einen Ultraschallmotor, einen Aktor 1, der ein Friktionselement 25 enthält, das mit einer beweglichen Friktionsschiene 37 zusammenwirkt. Der Aktor 1 wird mit einer Feder 38 an die bewegliche Friktionsschiene 37 gepresst.

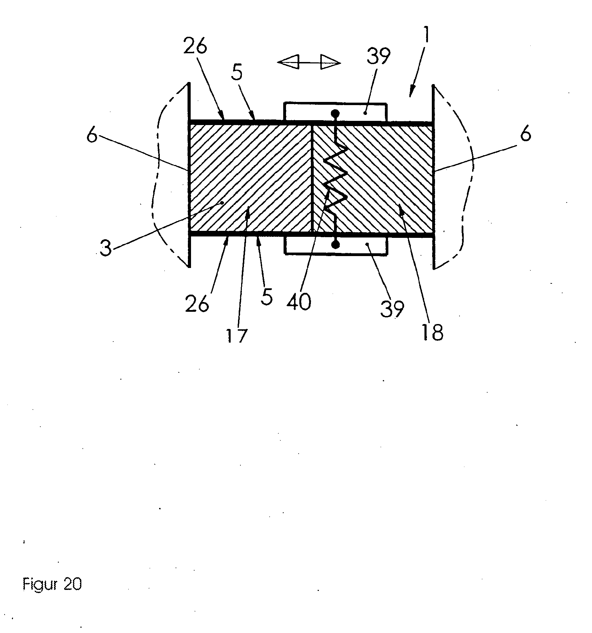

Fig. 20 zeigt einen Ultraschallmotor und einen Aktor 1 mit zwei Friktionsschichten 26, die mit Gleitstücken 39 zusammenwirken, die mit einer Zugfeder 40 auf die Seitenflächen 5 des Aktors 1 gepresst werden.

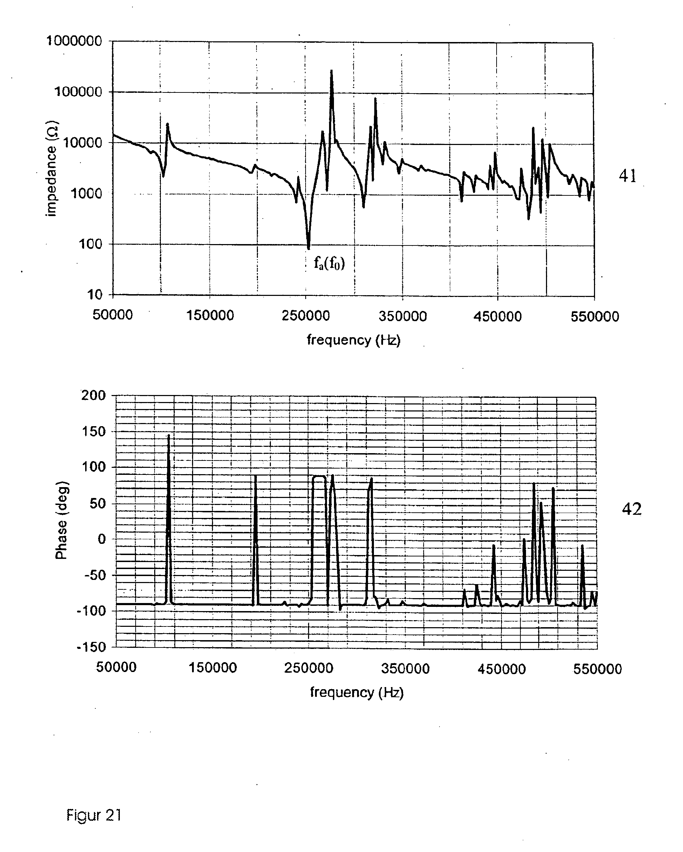

In Fig. 21 zeigt Pos. 41 die Abhängigkeit des Eingangswiderstandes Z des Aktors 1 von der Frequenz f der elektrischen Erregerspannung U und Pos 42 die Abhängigkeit der Phasenverschiebung V zwischen der elektrischen Erregerspannung U vom Strom i. Die Arbeitsfrequenz des Aktors 1 ist gleich der Frequenz fₐ.

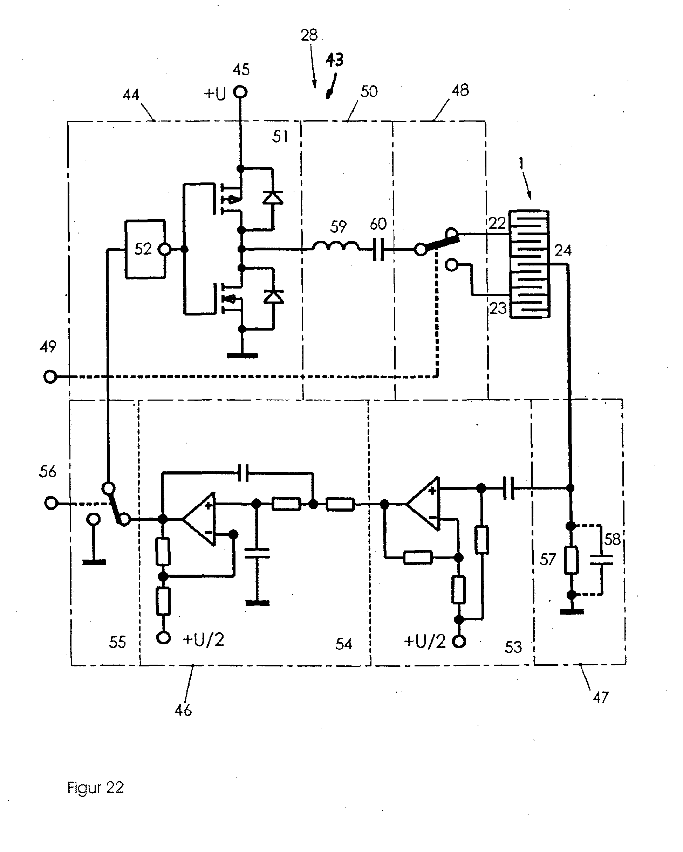

In der erfindungsgemäßen Ausführung des Autogenerators 28 entsprechend Fig. 22 kann die Steuerung 27 als Einkanalautogenerator 43 aufgebaut sein. Ein solcher Autogenerator kann aus einem Leistungsschalter 44 mit einem Spannungsversorgungseingang 45, einem Rückkopplungszweig 46, einem Rückkopplungselement 47, einem Richtungsumschalter 48 mit einem Steuereingang 49 und einem durchstimmbaren Filter 50 aufgebaut sein. Die Versorgungsspannung U wird an den Spannungsversorgungseingang 45 angelegt.

Der Leistungsverstärker 44 kann aus einem Halbbrückenendverstärker 51 und einem Treiber 52 bestehen. Der Rückkopplungszweig 46 kann ein Verstärkerglied 53, ein Filterglied 54 und einen Ausschalter 55 mit Steuereingang 56 enthalten. Das Rückkopplungselement 47 kann einen Widerstand 57, einen Kondensator 58 oder auch beide enthalten, die dann parallel geschaltet und mit der Gruppe der gemeinsamen Elektroden 8 verbunden sind. Das abstimmbare Filter 50 kann aus einer Spuleninduktivität 59 und einem Kondensator 60 des Serien-LC-Kreises bestehen.

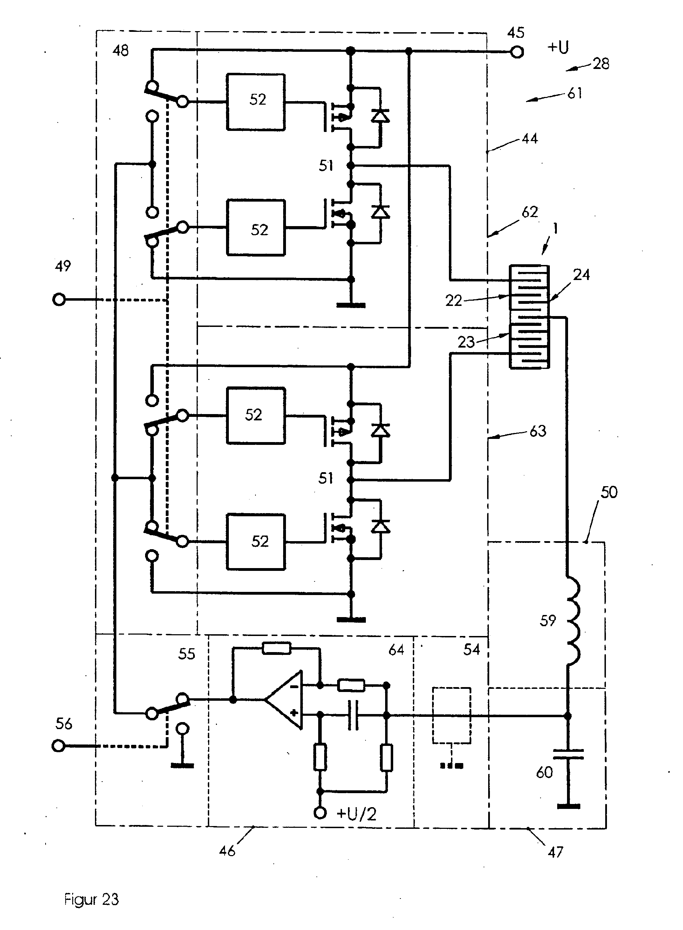

In der in Fig. 23 gezeigten weiteren erfindungsgemäßen Ausführungsvariante des Autogenerators 28 kann die Steuerung 27 als Zweikanalautogenerator 61 ausgeführt sein. Ein solcher Autogenerator 61 besteht aus zwei Kanälen 62 und 63 bildenden Leistungsverstärkern 44.

In allen Varianten des Autogenerators kann an Stelle des Rückkopplungselementes 47 der Kondensator 60 des durchstimmbaren Filters 50 verwendet werden, und der Rückkopplungszweig 46 kann zusätzlich ein Phasenschieberglied 64 enthalten (siehe Fig. 23).

In allen Ausführungsvarianten kann die elektrische Kapazität des Kondensators 60 des durchstimmbaren Filters 50 gleich der elektrischen Kapazität zwischen einer der Gruppen der Anregungselektroden 13 oder 14 und der Gruppe der gemeinsamen Elektroden sein.

In der folgenden Ausführung kann die Steuerung 27 aus einem Breitimpulsspannungsregler 65 mit dem Spannungsversorgungseingang 66 bestehen, dessen Ausgang 67 mit dem Spannungsversorgungseingang 45 des Autogenerators 28 verbunden ist.

Der Breitimpulsspannungsregler 65 besteht aus einem Leistungsverstärker 68, einem Filter 69 und einem Analogsignalwandler für ein Breitimpulssignal 70 mit einem Analogsteuereingang 71. Der Wandler kann auch einen Synchronisierungseingang 72 enthalten.

Der Synchronisierungseingang 72 kann mit einem Signalkreis 73 des Autogenerators 28 direkt oder über einen Frequenzvervielfacher 74 verbunden sein.

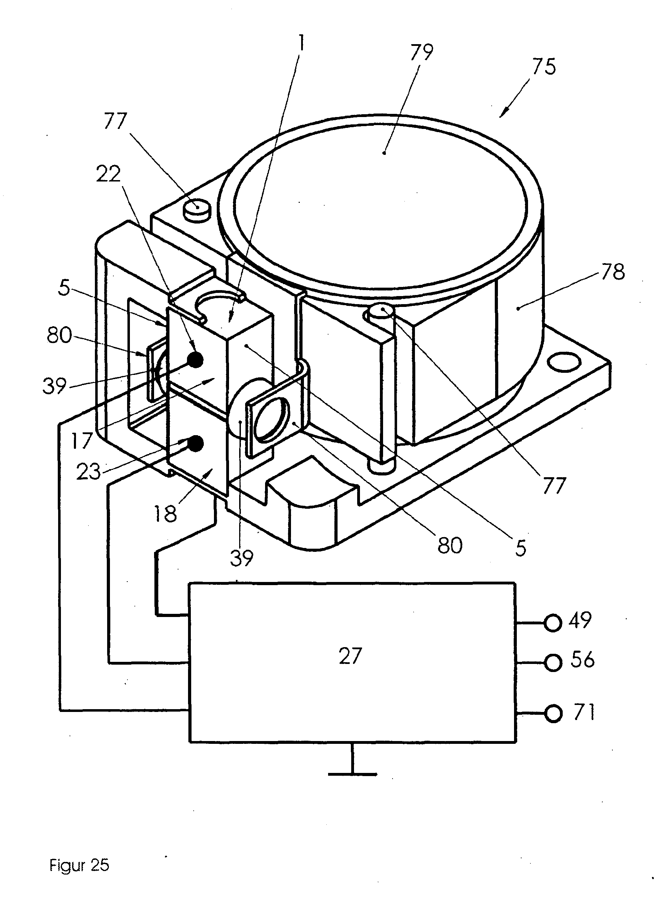

Fig. 25 zeigt einen erfindungsgemäßen Aktor zum Antrieb einer optischen Fokussierungseinheit 75. Der Aktor 1 ist in einem Gehäuse 76 der Fokussierungseinheit 75 untergebracht, auf der Führungen 77 mit den auf ihnen verschiebbaren Haltern 78 einer Linsengruppe 79 befestigt sind. Der Aktor 1 wird mittels der Profilfeder 80 an die Seitenflächen 5 der als Halbkugeln ausgeführten Gleitstücke 39 angepresst.

Der vorgeschlagene piezoelektrische Aktor 1 funktioniert wie folgt: Beim Anlegen einer Versorgungsspannung an die Steuerung 27 wird durch den Autogenerator 28 eine Spannung erzeugt, deren Frequenz gleich der Arbeitsfrequenz fₒ des Aktors 1 ist (siehe Fig. 17,18, Pos. 30). Diese Spannung gelangt auf die gemeinsamen Elektroden 8 und auf die Gruppe 13 oder 14 der Anregungselektroden 7, die zusammen mit den Schichten der piezoelektrischen Keramik 9 die Multilayergeneratoren 17 und 18 für die akustische Stehwelle bilden.

Dadurch bildet sich zwischen den Elektrodengruppen 8 und 7 ein zeitlich veränderliches, auf die Schicht 9 der Piezokeramik (siehe Fig. 3) einwirkendes elektrisches Feld E, dessen Vektor längs zur Polarisationsrichtung der Piezokeramik ausgerichtet ist, d.h. längs zur Polarachse 12 der Piezokeramikplatte 3. Da die Piezokeramikschichten 9 dünn sind (30-50 Mikrometer), ist es möglich, mit kleinen elektrischen Spannungen im Aktor ein ausreichend großes elektrisches Feld zu erzeugen. Deshalb kann die für die Ansteuerung des Aktors 1 erforderliche elektrische Spannung wesentlich gesenkt werden.

Das auf die Piezokeramik einwirkende elektrische Wechselfeld E bewirkt, dass die Piezokeramikplatte 3 beginnt, sich im Takt der Frequenz f₀ längs zur Polarachse 12 und zudem in zwei zueinander senkrechten Richtungen abwechselnd zu dehnen und bzw. zusammenzuziehen. Das Piezomodul d₃₃ beschreibt den Wirkungsgrad der Deformation der Platte 3 längs zur Polarachse und das Piezomodul d₃₁ in den beiden anderen zueinander senkrechten Richtungen.

Die Polarachse 15 kann senkrecht zu den Stirnflächen 6 (siehe Fig. 1, 4), senkrecht zu den Seitenflächen 5 (siehe Fig. 6) und auch senkrecht zu ihren Hauptflächen 4 (siehe Fig. 11) verlaufen.

Es ist die Steuerung 27 so ausgeführt, dass die von der Versorgungsspannung U erzeugte Arbeitsfrequenz f₀ automatisch gleich der Resonanzfrequenz fa (oder nahe dieser) gehalten wird, wobei diese gleich der Resonanzfrequenz der asymmetrischen Schwingungen der Platte 3 des Aktors 1 ist (siehe Fig. 19, Pos. 37), bei der durch die Generatoren 17 oder 18 eine asymmetrische Stehwelle im Aktor 1 erzeugt wird. Diese Welle unterscheidet sich von anderen Wellentypen dadurch, dass bei ihrer Erregung sich eine vorherrschende Neigung der Bewegungsbahn der auf den Seitenflächen 5 der Platte 3 liegenden Punkte einstellt.

Die Länge L und die Höhe H der Platte 3 stellen die Resonanzabmessungen für die angeregte Welle dar. Die Dicke der Platte 3 stellt keine Resonanzabmessung dar. Deshalb sind die Hauptdeformationskomponenten der Erregerwelle immer parallel zu den Hauptflächen 4 der Platte 3 verlaufenden Flächen angeordnet. Die Platte 3 wird nur unwesentlich in der Dicke deformiert. Die generierte Welle stellt deshalb eine parallel zu den Hauptflächen 4 der Platte 3 verlaufende "Flächen"-Welle dar.

Fig. 18, Pos. 31 und 32 zeigen die zwei bei der Generierung einer asymmetrischen Stehwelle im Aktor 1 entstehenden Deformationsphasen der Hauptfläche 4 der piezoelektrischen Platte 3. Die Abbildungen sind um eine halbe Schwingungsperiode zeitverschoben. Die Asymmetrie der Stehwelle wird in Fig. 18, Pos. 33 erläutert, die außerdem die Bewegungsbahnen der Punkte 34, der Punkte 35 auf der Seitenfläche 5 der Platte 3 zeigt. Die Linie 36 stellt die Hüllkurve der Bewegung 34 dar. Diese Linie wiederholt asymmetrisch die Bewegung der Fläche 15. Pos 33 zeigt die vorherrschende vom Generator 17 oder 18 weg gerichtete Neigung der Bewegungsbahn der Punkte 34.

Das Auftreten der Resonanz und die Resonanzfrequenz der asymmetrischen Stehwelle selbst wird durch das gewählte Verhältnis L/H und die konstruktive Ausführung der Generatoren 17, 18 für akustische Schwingungen bestimmt, wobei diese Generatoren asymmetrisch (siehe Fig. 18, Pos. 30) zur Symmetriefläche 15 der Platte 3 angeordnet sind (untereinander sind die Generatoren 17, 18 symmetrisch zur Symmetriefläche 15 angeordnet). Das optimale Verhältnis L/H beträgt etwa 2,25. Die Resonanzfrequenz fₐ der Platte mit dem optimalen Verhältnis L/H kann nach der Formel fₐ=N/L bestimmt werden, wobei N die Frequenzkonstante der Piezokeramik für den jeweiligen Stehwellentyp und das verwendete piezokeramisches Material ist. Für die Piezokeramik PIC 181 der Firma PI Ceramic ist N=4352 kHz mm.

Fig. 19 zeigt eine Variante des Ultraschallmotors, bei der auf der Seitenfläche 5 der Platte 3 ein Friktionselement 25 befestigt ist. Durch die Generierung einer asymmetrischen Stehwelle in der Platte 3 schwingt das Friktionselement 25 zusammen mit der Fläche 5 auf einer zur beweglichen Friktionsschiene 37 geneigten Bewegungsbahn, wodurch das Friktionselement gezwungen ist, sich in einer Richtung weg vom Generator 17 oder 18 zu bewegen, und zwar in Abhängigkeit davon, an welchem Generator die elektrische Spannung anliegt.

Fig. 20 zeigt eine Variante des Ultraschallmotors mit auf den Seitenflächen 5 der Platte 3 aufgebrachten Friktionsschichten 26. Durch die Generierung einer asymmetrischen Stehwelle in der Platte 3 bewegen sich die Punkte im Zentrum der Friktionsschichten 26 auf geneigten Bahnen, wodurch die Gleitstücke gezwungen sind, sich vom angesteuerten Generator 17 oder 18 weg zu bewegen.

Fig. 21, Pos. 41 zeigt die Abhängigkeit der Eingangsimpedanz Z des Aktors 1 von der Frequenz der Erregerspannung U im Bereich von 50 bis 550 kHz. In der Grafik ist ein Aktor 1 mit dem Abmessungen 16x6,6x3 mm aus Piezokeramik PIC 181 der Firma PI ceramic dargestellt. Pos. 38 zeigt die Abhängigkeit der Phasenverschiebung V der Erregerspannung U vom Strom I (siehe Pos. 30, Fig. 18) für diesen Aktor 1.

Aus der Abhängigkeit der Impedanz Z von der Frequenz (Pos. 41) ist ersichtlich, dass im Bereich der Frequenz fₐ nur eine stark ausgeprägte Resonanz auftritt. Diese Resonanz ist in einem breiten Bereich besonders stark ausgeprägt. Dabei ist bei der Frequenz fₐ der elektrische Widerstand des Aktors 1 ungefähr zehn mal kleiner als in anderen Resonanzfrequenzbereichen.

Da der Winkel der Phasenverschiebung V bei der Frequenz fₐ gleich 0 ist, ist es möglich, einfach konstruierte Erregereinheiten für den Aktor 1 zu bauen, die auf dem Prinzip der Selbsterregung beruhen, wobei die Frequenz der Erregerspannung für den Aktor 1 durch die mechanischen Parameter des Aktors vorgegeben wird.

Dies ist dadurch erklärbar, das bei der Resonanzfrequenz fₐ der Blindwiderstand des Aktors 1 durch den Blindwiderstand der mechanischen Kapazität kompensiert wird, wodurch bei dieser Frequenz die Phasenverschiebung V gleich Null wird. D.h. die Nulllage der Phasenverschiebung auf der Frequenzskala wird durch Gewicht und Härte des Aktors 1 bestimmt.

Zur automatischen Einstellung der Frequenz f₀ der Spannung U, die annähernd gleich der Resonanzfrequenz fₐ ist, besteht die vorschlagsgemäße Ausführung der Steuerung 27 aus einem Autogenerator 28 (Fig. 17).

Im Allgemeinen stellt die elektrische Schaltung des Autogenerators 28 einen geschlossenen Kreis von Gliedern mit positiver Rückkopplung dar, bei der die Phasenverschiebung bei der Frequenz fₐ gleich 0 bzw. 360° ist, wobei bei dieser Frequenz der Verstärkungskoeffizient größer 1 ist.

Fig. 22 zeigt die elektrische Schaltung der Einkanalvariante des Autogenerators 28. In dieser Variante besteht der geschlossene Kreis von Gliedern aus dem Aktor 1 mit dem Rückkopplungselement 47, dem Rückkopplungszweig 46 mit dem Verstärkerglied 53, dem Filterglied 54, dem Ausschalter 55, dem Leistungsverstärker 44 und dem durchstimmbaren Filter 50.

In dieser Variante des Autogenerators stellt der Widerstand 57 das Rückkopplungselement dar, an dem die Spannung proportional zum durch den Aktor fließenden Strom I ist. Das Verstärkerglied 53 dient der Signalverstärkung im Rückkopplungszweig 46. Das Filterglied 54 dient der Filterung der ersten Harmonischen aus dem Rückkopplungssignal, das im Rückkopplungszweig 46 mit dem Verstärkerelement 53 gebildet wird. Der Verstärker ist ein Leistungsverstärker 44 für den Aktor 1. Das abstimmbare Filter 50 ist für die Abstimmung des Halbbrückenendverstärkers 51 auf dem Aktor 1 erforderlich.

Das Filterglied 54 und das abstimmbare Filter 50 sind Bandfilter mit großer Durchlassbandbreite, deren Resonanzfrequenzen auf die Frequenz fₐ des Aktors 1 abgestimmt sind. Die Durchlassbandbreite dieser Filter bewegt sich bei 10... 30% der Frequenz fₐ. Der Aktor 1 mit dem Widerstand 57 des Rückkopplungselements 47 stellt ein Schmalbandfilter mit einer Durchlassbandbreite von 0,5...1,0% dar.

Die Elemente 50 und 54 rufen bei der Frequenz fₐ keine Phasenverschiebung hervor, bewirken aber bei allen anderen Frequenzen eine Phasenverschiebung. Das Ausbleiben der Phasenverschiebung bei der Frequenz fₐ bedeutet, dass bei einer dementsprechenden Auswahl des Verstärkungskoeffizienten des Verstärkerglieds 53, wobei dieser im gesamten Stromkreis des Autogenerators 28 bei der Frequenz fa größer 1 ist, der Autogenerator 28 immer auf der Frequenz fₐ anschwingt. Da die Durchlassbandbreite des Aktors 1 mit dem Rückkopplungselement 57 bedeutend kleiner als die Durchlassbandbreite der Elemente 54 und 50 ist, bestimmt der Aktor 1 in erster Linie die Erregerfrequenz des Autogenerators 28.

Der Ausschalter 55 ermöglicht die Trennung des Rückkopplungszweigs 46 vom Treiber 52 des Leistungsverstärkers 44, wodurch die Selbsterregung des Generators 28 beendet wird.

Ein Kondensator 58 als Rückkopplungselement 47 wird verwendet, wenn nur eine geringe Phasenverschiebung des Autogenerators 28 zur Frequenz fₐ erforderlich ist.

Fig. 23 zeigt die Zweikanalvariante 61 des Autogenerators 28. Dabei besteht der Autogenerator 28 aus den Kanälen 62 und 63, die mittels des Richtungsumschalters 48 mit dem Rückkopplungszweig 46 verbunden werden. Die Kanäle 62, 63 und der Richtungswahlschalschalter 48 sind so ausgeführt, dass beim Verbinden des Kanals 62 oder 63 mit dem Rückkopplungszweig 46, die stromleitende Elektrode 22 oder 23 getrennt vom Nulleiter und vom Spannungsversorgungseingang 45 wird. Dies erhöht den Wirkungsgrad des Aktors 1.

In allen Varianten des Autogenerators 28 kann als Rückkopplungselement 47 der Kondensator 60 des durchstimmbaren Filters 50 verwendet werden. Das erhöht den Signalpegel der Rückkopplung.

Die am Kondensator 60 anliegende elektrische Spannung ist um 90° phasenverschoben, bezogen auf den durch den Aktor fließenden Strom I. Das Phasenschieberglied 64 dient der Phasenkompensation im Rückkopplungszweig, wodurch das Signal um 90° in entgegengesetzter Richtung verschoben wird.

Die Kapazität des Kondensators 60 des Serien-LC-Kreises des durchstimmbaren Filters 50 kann gleich der elektrischen Kapazität des Aktors sein, die sich zwischen einer der Gruppen der Anregungselektroden und der Gruppe der gemeinsamen Elektroden bildet. Das verbessert die Kennwerte des durchstimmbaren Filters, wodurch sein charakteristischer Widerstand im optimalen Verhältnis zum Widerstand des Aktors 1 steht.

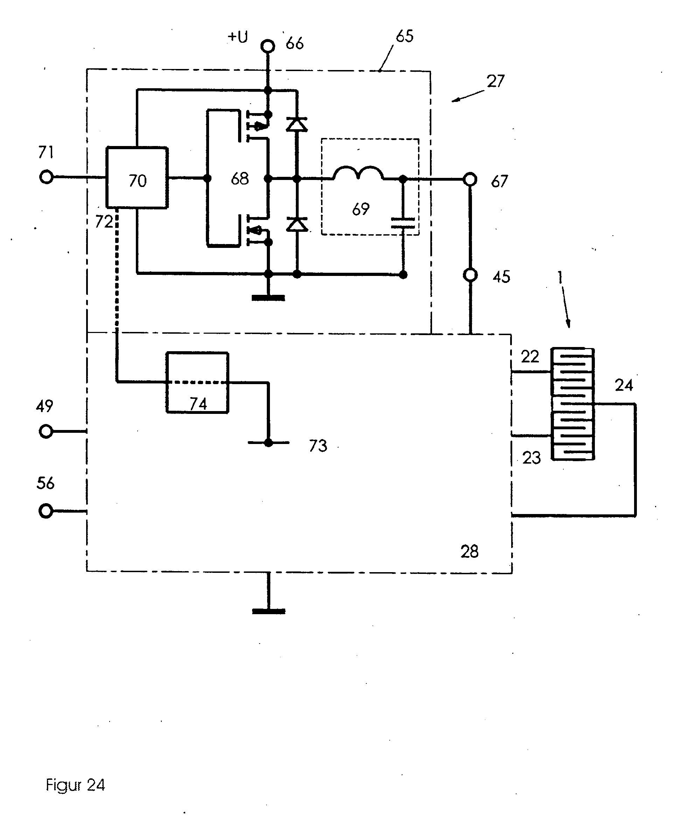

Fig. 24 zeigt eine Ausführungsvariante der Steuerung 27, die zusätzlich einen Breitimpulsspannungsregler 65 enthält. Der Breitimpulsspannungsregler 65 enthält einen Analogsignalwandler für ein Breitimpulssignal 70 mit einem Analogsteuereingang 71. Dieser Wandler erzeugt ein Breitimpulssignal, das über den Leistungsverstärker 68 auf das Filter 69 gelangt.

Die am Ausgang 67 des Wandlers 65 anliegende elektrische Spannung ist proportional zur Analogspannung am Ausgang 71. Vom Ausgang 67 gelangt die elektrische Spannung auf den Spannungsversorgungseingang 45 des Leistungsverstärkers 44. Die Spannungsänderung am Eingang 45 führt zu einer Vergrößerung oder Verringerung des Anregungsniveaus für den Aktor 1.

Der Wandler 70 kann einen Synchronisierungseingang 72 enthalten, der direkt mit dem Signalkreis 73 des Autogenerators 28 bzw. über den Frequenzvervielfacher 74 mit dem Signalkreis verbunden ist.

Die Aktorvariante in Fig. 20 funktioniert folgendermaßen: Sobald die Erregerspannung von der Steuerung 27 am Generator 17 oder 18 anliegt, veranlasst der Aktor 1 die mit der Feder 80 an die Seitenflächen 5 des Aktors 1 angepressten Gleitstücke 39, sich zu bewegen. Die Bewegung der Gleitstücke wird über die Feder 80 an die Halter übertragen, wodurch die Linsengruppe 79 auf den Führungen 77 verschoben wird.

In der erfindungsgemäßen Ausführung ist es durch Verzicht auf der metallischen akustischen Schwingungsresonator möglich, die Aktorabmessungen um das 3- bis 5-fache zu verringern. Die Erfindung ermöglicht es außerdem, die elektrische Erregerspannung des Aktors ungefähr um das 100-fache zu verkleinern. Die Betriebsstabilität des Aktors ist wesentlich höher, da Klebeverbindungen zwischen dem akustischen Schwingungsresonator und dem piezoelektrischen Wandler entfallen. Durch die Erfindung ist es möglich, einfache Aktorsteuerungen aufzubauen, bei denen die den Aktor anregende Frequenz der elektrischen Spannung durch den Aktor selbst erzeugt wird. Dies führt zu einer wesentlichen Erhöhung der Betriebsstabilität des Aktors über einen großen Temperaturbereich und Bereich mechanischer Belastung. Durch die Multilayertechnologie ist es möglich, den Herstellungsprozess zu automatisieren und dadurch die Herstellungskosten zu senken. Zudem können durch die einfachere Konstruktion der Steuerung ihre Kosten um ein Vielfaches gesenkt werden.

### Bezugsziffern

- 1.: Aktor
- 2.: akustischer Schwingungsresonator
- 3.: rechtwinklige piezoelektrische Platte
- 4.: Hauptflächen der Platte 3
- 5.: Seitenflächen der Platte 3
- 6.: Stirnflächen der Platte 3
- 7.: Anregungselektroden
- 8.: Gemeinsame Elektroden
- 9.: Piezokeramikschicht
- 10,11.: Polarisationsrichtungen der Piezokeramik
- 12.: Polarachse der Piezokeramikplatte 3
- 13, 14.: Gruppen von Anregungselektroden 7
- 15.: Symmetriefläche
- 16.: Schnittlinie der Symmetriefläche mit den Kanten 4 und 5
- 17, 18.: Multilayergeneratoren für akustische Stehwellen
- 19,20.: Teile der gemeinsamen Elektroden 8
- 21.: Stromleitender Ansatz
- 22, 23, 24: Stromleitende Elektroden
- 25.: Friktionselement
- 26.: Friktionsschicht
- 27.: Steuerung
- 28.: Autogenerator
- 29.: Richtungswahlschalter der Steuerung 27
- 30.: Schematische Darstellung der Platte 3
- 31, 32: Deformationsbilder der Platte 3
- 33.: Abb. der Bewegungsbahnen der Punkte.
- 34.: Bewegungsbahn der Punkte 35
- 35.: Oberflächenpunkte der Seitenfläche 5
- 36.: Hüllkurve der Bewegungsbahn 34
- 37.: Bewegliche Friktionsschiene
- 38.: Feder
- 39.: Gleitstück
- 40.: Zugfeder
- 41.: Impedanz-Frequenzabhängigkeit des Aktors 1
- 42.: Phasen-Frequenzabhängigkeit des Aktors 1
- 43.: Einkanalautogenerator
- 44.: Leistungsverstärker für den Autogenerator 28
- 45.: Spannungsversorgungseingang für den Leistungsverstärker 44
- 46.: Rückkopplungszweig
- 47.: Rückkopplungselement
- 48.: Richtungsumschalter des Autogenerators 28
- 49.: Steuereingang des Umschalters 48
- 50.: abstimmbares Filter
- 51.: Halbbrückenendverstärker
- 52.: Treiber
- 53.: Verstärkerglied
- 54.: Filterglied
- 55.: Ausschalter
- 56.: Steuereingang des Ausschalters 55
- 57.: Widerstand als Rückkopplungselement 47
- 58.: Kondensator als Rückkopplungselement 47
- 59.: Spuleninduktivität des durchstimmbaren Filters 50
- 60.: Kondensator des durchstimmbaren Filters 50
- 61.: Zweikanalautogenerator
- 62,63.: Kanäle des Autogenerators 61
- 64.: Phasenschieberglied des Rückkopplungszweiges 46
- 65.: Breitimpulsspannungsregler
- 66.: Spannungsversorgungseingang des Breitimpulsspannungsregler 65
- 67.: Ausgang des Breitimpulsspannungsregler 65
- 68.: Leistungsverstärker des Breitimpulsspannungsregler 65
- 69.: Filter des Breitimpulsspannungsreglers 65
- 70.: Analogsignalwandler für ein Breitimpulssignal
- 71.: Analogsteuereingang für den Analogsignalwandler 70
- 72.: Synchronisierungseingang des Analogsignalwandlers 70
- 73.: Signalkreis des Autogenerators 28.
- 74.: Frequenzvervielfacher
- 75.: Optische Fokussierungseinheit
- 76.: Gehäuse der Einheit 75
- 77.: Führungen
- 78.: Halter für optische Linsengruppe
- 79.: Optische Linsengruppe
- 80.: Profilfeder

## Patentansprüche

1. Piezoelektrischer Aktor (1), insbesondere für einen Ultraschallmotor, mit einem akustischen Schwingungsresonator (2), der im Wesentlichen die Form einer rechteckigen piezokeramischen Platte (3) mit zwei Haupt- (4), zwei Seiten- (5) und zwei Stirnflächen (6) aufweist, wobei mindestens auf einer der Seitenflächen ein Friktionselement (25) oder eine Friktionsschicht (26) angeordnet ist und der Schwingungsresonator im Inneren eine
Multilayerstruktur hat,
**dadurch gekennzeichnet, dass**
die Multilayerstruktur Schichten von Anregungselektroden (7) darstellt, die sich mit Schichten gemeinsamer Elektroden (8) und zwischen ihnen sich befindenden Schichten polarisierter Keramik (9) abwechseln, wobei der Polarisationsvektor senkrecht zur Fläche der Elektroden verläuft, alle Anregungselektroden (7) in zwei nicht miteinander verbundene Gruppen (13; 14) geteilt sind, die symmetrisch zur Symmetriefläche (15) der piezokeramischen Platte angeordnet sind, wobei diese Symmetriefläche senkrecht zu den Haupt- sowie Seitenflächen der Platte durch ihre Mitte verläuft, und jede der Gruppen der Anregungselektroden (13; 14) zusammen mit den gemeinsamen Elektroden (8) und der Piezokeramik (9) zwischen ihnen je einen auf die Symmetriefläche der piezoelektrischen Platte bezogenen asymmetrisch angeordneten Multilayergenerator für eine asymmetrische akustische Stehwelle bildet, wobei das Verhältnis der Länge (L) zur Höhe (H) der piezokeramischen Platte im Wesentlichen 2,25 beträgt und die Erregerfrequenz fₐ der piezokeramischen Platte dem Verhältnis Länge (L) der piezokeramischen Platte zur Frequenzkonstante (N) der piezokeramischen Platte entspricht und die Länge (L) längs der Seiten Fläche (5) und die Höhe (H) längs der Stirnfläche (6) gemessen werden.

2. Piezoelektrischer Aktor nach Anspruch 1,
**dadurch gekennzeichnet, dass**
die gemeinsamen Elektroden (8) aus zwei Teilen bestehen, deren Konfiguration die Konfiguration der Anregungselektroden (7)wiederholt.

3. Piezoelektrischer Aktor nach Anspruch 1 oder 2,
**dadurch gekennzeichnet, dass**,
die Anregungselektroden (7) und die gemeinsamen Elektroden (8) parallel zu den Stirnflächen (6) der piezoelektrischen Platte (3) angeordnet sind.

4. Piezoelektrischer Aktor nach Anspruch 1 oder 2,
**dadurch gekennzeichnet, dass**
die Anregungselektroden (7) und die gemeinsamen Elektroden (8) parallel zu den Seitenflächen (5) der piezoelektrischen Platte (3) angeordnet sind.

5. Piezoelektrischer Aktor nach Anspruch 1 oder 2,
**dadurch gekennzeichnet, dass**
die Anregungselektroden (7) und die gemeinsamen Elektroden (8) parallel zu den Hauptflächen (4) der piezoelektrischen Platte (3) angeordnet sind.

6. Piezoelektrischer Aktor nach einem der vorangehenden Ansprüche,
**dadurch gekennzeichnet, dass**
mindestens auf einer Seitenfläche (5) der piezoelektrischen Platte (3) stromleitende Elektroden (22; 23; 24) aufgebracht sind, die die Anregungselektroden (7) und gemeinsamen Elektroden (8) untereinander verbinden.

7. Piezoelektrischer Aktor nach einem der Ansprüche 1 bis 5,
**dadurch gekennzeichnet, dass**
mindestens auf einer Hauptfläche (4) der piezoelektrischen Platte (3) stromleitende Elektroden (22; 23; 24) aufgebracht sind, die die Anregungselektroden (7) und gemeinsamen Elektroden (8) untereinander verbinden.

8. Piezoelektrischer Aktor nach einem der Ansprüche 1 bis 5,
**dadurch gekennzeichnet, dass**
auf den Stirnflächen (6) der piezoelektrischen Platte (3) stromleitende Elektroden (22; 23; 24) aufgebracht sind, die die Anregungselektroden (7) und gemeinsamen Elektroden (8) untereinander verbinden.

9. Piezoelektrischer Aktor nach einem der vorangehenden Ansprüche,
**gekennzeichnet durch**
eine einen Ein- oder Zweikanalautogenerator (28) aufweisende Steuereinheit (27).

10. Piezoelektrischer Aktor nach Anspruch 9,
**dadurch gekennzeichnet, dass**
die Steuereinheit einen Einkanalautogenerator (43) mit Leistungsverstärker (44) mit durchstimmbarem Filter aufweist, mit einem Rückkopplungszweig (46), der mit dem Rückkopplungselement (47) und einem Richtungsumschalter (48) verbunden ist, der abwechselnd den Leistungsverstärker (44) mit dem entsprechenden Generator (17;18) für akustische Wellen verbindet.

11. Piezoelektrischer Aktor nach Anspruch 9,
**dadurch gekennzeichnet, dass**
die Steuereinheit einen Zweikanalautogenerator (61) mit zwei Leistungsverstärkern (44) aufweist, mit einem Rückkopplungszweig (46), der mit dem Rückkopplungselement (47) und dem Richtungsumschalter (48) verbunden ist, der abwechselnd den Rückkopplungszweig (46) mit dem entsprechenden Kanal (62; 63) des Autogenerators (61) verbindet.

12. Piezoelektrischer Aktor nach Anspruch 10 oder 11,
**dadurch gekennzeichnet, dass**
das Rückkopplungselement (47) aus einem Widerstand (57), einem Kondensator (58) oder aus beiden parallel geschalteten Bauteilen (57; 58) besteht und mit der Gruppe der gemeinsamen Elektroden (8) des piezoelektrischen Aktors verbunden sind.

13. Piezoelektrischer Aktor nach Anspruch 10 oder 11,
**dadurch gekennzeichnet, dass**
das Rückkopplungselement (47) einen Kondensator eines durchstimmbaren Filters (60) in Form eines Serien-LC-Kreises, der mit der Gruppe der gemeinsamen Elektroden (8) des piezoelektrischen Aktors verbinden ist, aufweist.

14. Piezoelektrischer Aktor nach Anspruch 13,
**dadurch gekennzeichnet, dass**
die elektrische Kapazität des Kondensators des Serien-LC-Kreises (60) gleich der elektrischen Kapazität des Aktors (1) zwischen einer der Gruppen der Anregungselektroden (7) und einer Gruppe der gemeinsamen Elektroden (8) ist.

15. Piezoelektrischer Aktor nach einem der Ansprüche 9 bis 14,
**dadurch gekennzeichnet, dass**
die Steuereinheit (27) zusätzlich einen Breitimpulsspannungsregler (65) enthält, dessen Ausgang (67) mit dem Eingang der Spannungsquelle des Einkanal- oder Zweikanalautogenerators verbunden ist, wobei sein Steuereingang einen Analogeingang zur Steuerung des Anregungsniveaus des Aktors bildet.

16. Piezoelektrischer Aktor nach Anspruch 15,
**dadurch gekennzeichnet, dass**
der Synchronisierungseingang (72) des Breitimpulsspannungsregler(65) mit dem Signalkreis (73) eines Einkanal- oder Zweikanalautogenerators direkt oder über einen Frequenzvervielfacher (74) verbunden ist.

## Claims

1. Piezoelectric actuator (1), especially for an ultrasonic motor, comprising an acoustic oscillation resonator (2) which is substantially formed as a rectangular piezoceramic plate (3) with two main surfaces (4), two side surfaces (5) and two end faces (6), wherein a friction element (25) or a friction layer (26) is provided on at least one of the side surfaces and the oscillation resonator has a multilayer structure in the interior,
**characterized in that**
the multilayer structure represents layers of excitation electrodes (7) taking turns with layers of common electrodes (8) and layers of polarized ceramic (9) provided therebetween, wherein the polarization vector extends perpendicularly with respect to the surface of the electrodes, all excitation electrodes (7) are divided into two groups (13; 14) not connected to each other, which are disposed symmetrically with respect to the symmetry surface (15) of the piezoceramic plate, wherein this symmetry surface extends perpendicularly with respect to the main and side surfaces of the plate through the center thereof, and each of the groups of the excitation electrodes (13; 14) forms together with the common electrodes (8) and the piezoceramic (9) therebetween a multilayer generator for an asymmetrical acoustic standing wave which is arranged asymmetrically with respect to the symmetry surface of the piezoelectric plate, wherein the ratio length (L) to height (H) of the piezoceramic plate is substantially 2.25 and the excitation frequency fa of the piezoceramic plate corresponds to the ratio length (L) of the piezoceramic plate to the frequency constant (N) of the piezoceramic plate, and length (L) is measured alongside of side surface (5) and height (H) is measured alongside of end face (6).

2. Piezoelectric actuator according to claim 1,
**characterized in that**
the common electrodes (8) are comprised of two parts the configuration of which repeats the configuration of the excitation electrodes (7).

3. Piezoelectric actuator according to claim 1 or 2,
**characterized in that**
the excitation electrodes (7) and the common electrodes (8) are arranged in parallel to the end faces (6) of the piezoelectric plate (3).

4. Piezoelectric actuator according to claim 1 or 2,
**characterized in that**
the excitation electrodes (7) and the common electrodes (8) are arranged in parallel to the side surfaces (5) of the piezoelectric plate (3).

5. Piezoelectric actuator according to claim 1 or 2,
**characterized in that**
the excitation electrodes (7) and the common electrodes (8) are arranged in parallel to the main surfaces (4) of the piezoelectric plate (3).

6. Piezoelectric actuator according to one of the preceding claims,
**characterized in that**
electrically conductive electrodes (22; 23; 24) are mounted on at least one side surface (5) of the piezoelectric plate (3), which connect the excitation electrodes (7) and the common electrodes (8) to each other.

7. Piezoelectric actuator according to one of claims 1 to 5,
**characterized in that**
electrically conductive electrodes (22; 23; 24) are mounted on at least one main surface (4) of the piezoelectric plate (3), which connect the excitation electrodes (7) and the common electrodes (8) to each other.

8. Piezoelectric actuator according to one of claims 1 to 5,
**characterized in that**
electrically conductive electrodes (22; 23; 24) are mounted on the end faces (6) of the piezoelectric plate (3), which connect the excitation electrodes (7) and the common electrodes (8) to each other.

9. Piezoelectric actuator according to one of the preceding claims,
**characterized by**
a control unit (27) having a single- or dual-channel autogenerator (28)

10. Piezoelectric actuator according to claim 9,
**characterized in that**
the control unit comprises a single-channel autogenerator (43) with a power amplifier(44) with a variable-frequency filter, with a feedback loop (46) connected to the feedback element (47) and a direction reversing switch (48), which alternately couples the power amplifier (44) to the corresponding acoustic wave generator (17; 18).

11. Piezoelectric actuator according to claim 9,
**characterized in that**
the control unit comprises a dual-channel autogenerator (61) with two power amplifiers (44), with a feedback loop (46) connected to the feedback element (47) and the direction reversing switch (48), which alternately couples the feedback loop (46) to the corresponding channel (62; 63) of the autogenerator (61).

12. Piezoelectric actuator according to claim 10 or 11,
**characterized in that**
the feedback element (47) is formed of a resistor (57), a capacitor (58) or both components connected in parallel (57; 58), and is connected to the group of the common electrodes (8) of the piezoelectric actuator.

13. Piezoelectric actuator according to claim 10 or 11,
**characterized in that**
the feedback element (47) comprises a capacitor of a variable-frequency filter (60) in the form of a series LC circuit which is connected to the group of the common electrodes (8) of the piezoelectric actuator.

14. Piezoelectric actuator according to claim 13,
**characterized in that**
the electrical capacitance of the capacitor of the series LC circuit (60) is equal to the electrical capacitance of the actuator (1) between one of the groups of the excitation electrodes (7) and a group of the common electrodes (8).

15. Piezoelectric actuator according to one of claims 9 to 14,
**characterized in that**
the control unit (27) additionally comprises a broad pulse voltage controller (65) the output (67) of which is connected to the input of the voltage source of the single-channel or dual-channel autogenerator, with the control input thereof forming an analog input for controlling the excitation level of the actuator.

16. Piezoelectric actuator according to claim 15,
**characterized in that**
the synchronization input (72) of the broad pulse voltage controller (65) is connected to the signal circuit (73) of a single-channel or dual-channel autogenerator directly or via a frequency multiplier (74).

## Revendications

1. Actionneur piézoélectrique (1), en particulier pour un moteur à ultrasons, comprenant un résonateur d'oscillations acoustique (2) qui présente essentiellement la forme d'une plaque rectangulaire piézocéramique (3) avec deux faces principales (4), deux faces latérales (5) et deux faces frontales (6), dans lequel un élément de friction (25) ou une couche de friction (26) est agencé(e) au moins sur l'une des faces latérales, et le résonateur d'oscillations possède à l'intérieur une structure multicouche,
**caractérisé en ce que**
la structure multicouche représente des couches d'électrodes excitatrices (7), qui alternent avec des couches d'électrodes communes (8) et des couches, qui se trouvent entre celles-ci, de céramique polarisée (9), dont le vecteur de polarisation s'étend perpendiculairement à la surface des électrodes, toutes les électrodes excitatrices (7) sont subdivisées en deux groupes (13 ; 14) qui ne sont pas reliés l'un à l'autre et sont agencés symétriquement par rapport à la surface de symétrie (15) de la plaque piézocéramique, ladite surface de symétrie s'étendant perpendiculairement aux faces principales et aux faces latérales de la plaque par leur milieu, et chacun des groupes d'électrodes excitatrices (13 ; 14) forme, conjointement avec les électrodes communes (8) et avec la piézocéramique (9) entre elles, un générateur multicouche respectif agencé de façon asymétrique par référence au plan de symétrie de la plaque piézoélectrique, pour une onde stationnaire acoustique asymétrique, et le rapport de la longueur (L) sur la hauteur (H) de la plaque piézocéramique s'élève sensiblement à 2,25, et la fréquence d'excitation fa de la plaque piézocéramique correspond au rapport de la longueur (L) de la plaque piézocéramique sur la constante de fréquence (N) de la plaque piézocéramique, et la longueur (L) est mesurée le long des faces latérales (5) et la hauteur (H) est mesurée le long des faces frontales (6).

2. Actionneur piézoélectrique selon la revendication 1,
**caractérisé en ce que** les électrodes communes (8) sont constituées de deux parties, dont la configuration répète la configuration des électrodes excitatrices (7).

3. Actionneur piézoélectrique selon la revendication 1 ou 2,
**caractérisé en ce que** les électrodes excitatrices (7) et les électrodes communes (8) sont agencées parallèlement aux faces frontales (6) de la plaque piézoélectrique (3).

4. Actionneur piézoélectrique selon la revendication 1 ou 2,
**caractérisé en ce que** les électrodes excitatrices (7) et les électrodes communes (8) sont agencées parallèlement aux faces latérales (5) de la plaque piézoélectrique (3).

5. Actionneur piézoélectrique selon la revendication 1 ou 2,
**caractérisé en ce que** les électrodes excitatrices (7) et les électrodes communes (8) sont agencées parallèlement aux faces principales (4) de la plaque piézoélectrique (3).

6. Actionneur piézoélectrique selon l'une des revendications précédentes,
**caractérisé en ce qu'**au moins sur une face latérale (5) de la plaque piézoélectrique (3) sont appliquées des électrodes conductrices (22 ; 23 ; 24), qui connectent les électrodes excitatrices (7) et les électrodes communes (8) les unes aux autres.

7. Actionneur piézoélectrique selon l'une des revendications 1 à 5,
**caractérisé en ce qu'**au moins sur une face principale (4) de la plaque piézoélectrique (3) sont appliquées des électrodes conductrices (22 ; 23 ; 24) qui connectent les électrodes excitatrices (7) et les électrodes communes (8) les unes aux autres.

8. Actionneur piézoélectriques selon l'une des revendications 1 à 5,
**caractérisé en ce que** sur les faces frontales (6) de la plaque piézoélectriques (3) sont appliquées des électrodes conductrices (22 ; 23 ; 24) qui connectent les électrodes excitatrices (7) et les électrodes communes (8) les unes aux autres.

9. Actionneur piézoélectrique selon l'une des revendications précédentes,
**caractérisé par** une unité de commande (27) comprenant un autogénérateur (28) à un canal ou à deux canaux.

10. Actionneur piézoélectrique selon la revendication 9,
**caractérisé en ce que** l'unité de commande comprend un autogénérateur (43) à un canal avec amplificateur de puissance (44) doté d'un filtre accordable, comprenant une branche de rétroaction (46) qui est connectée avec l'élément de rétroaction (47) et avec un inverseur directionnel (48), qui relie alternativement l'amplificateur de puissance (44) au générateur correspondant (17 ; 18) pour des ondes acoustiques.

11. Actionneur piézoélectrique selon la revendication 9,
**caractérisé en ce que** l'unité de commande comprend un autogénérateur à deux canaux (61) avec deux amplificateurs de puissance (44), comprenant une branche de rétroaction (46) qui est connectée avec l'élément de rétroaction (47) et avec l'inverseur directionnel (48), qui relie alternativement la branche de rétroaction (46) au canal correspondant (62 ; 63) de l'autogénérateur (61).

12. Actionneur piézoélectrique selon la revendication 10 ou 11,
**caractérisé en ce que** l'élément de rétroaction (47) est constitué par une résistance (57), par un condensateur (58) ou par les deux composants (57 ; 58) branchés en parallèle et sont connectés au groupe des électrodes communes (8) de l'actionneur piézoélectrique.

13. Actionneur piézoélectrique selon la revendication 10 ou 11,
**caractérisé en ce que** l'élément de rétroaction (47) comprend un condensateur d'un filtre accordable (60) sous la forme d'un circuit série LC, qui est connecté au groupe des électrodes communes (8) de l'actionneur piézoélectrique.

14. Actionneur piézoélectrique selon la revendication 13,
**caractérisé en ce que** la capacité électrique du condensateur du circuit série LC (60) est égale à la capacité électrique de l'actionneur (1) entre un des groupes des électrodes excitatrices (7) et un groupe des électrodes communes (8).

15. Actionneur piézoélectrique selon l'une des revendications 9 à 14,
**caractérisé en ce que** l'unité de commande (27) contient additionnellement un régulateur de tension à impulsion large (65), dont la sortie (67) est connectée à l'entrée de la source de tension de l'autogénérateur à un canal ou à deux canaux, et son entrée de commande forme une entrée analogique pour la commande du niveau d'excitation de l'actionneur.

16. Actionneur piézoélectrique selon la revendication de 15,
**caractérisé en ce que** l'entrée de synchronisation (72) du régulateur de tension à impulsion large (65) est connectée au circuit de signal (73) d'un autogénérateur à un canal ou à deux canaux soit directement soit via un multiplicateur de fréquence (74).
